# EUROPEAN PATENT SPECIFICATION

(11) **EP 0 272 755 B1**
(45) Date of publication and mention of the grant of the patent: **16.03.1994**
(21) Application number: 87202561.4
(22) Date of filing: 17.12.1987
(51) Int. Cl.: H01L 21/28, H01L 29/10, H01L 29/60, H01L 29/78, H01L 29/76

(54) **A method of manufacturing a semiconductor device**
Verfahren zur Herstellung eines Halbleiterbauelements
Procédé pour la fabrication d'un dispositif à semi-conducteur

(30) Priority: 23.12.1986 GB 8630814
(43) Date of publication of application: 29.06.1988
(73) Proprietor: PHILIPS ELECTRONICS UK LIMITED, Croydon CR9 3QR (GB); Philips Electronics N.V., 5621 BA Eindhoven (NL)
(72) Inventor: Coe, David James, Redhill RH1 5HA (GB); Whight, Kenneth Ronald, Redhill RH1 5HA (GB); Tree, Richard John, Redhill RH1 5HA (GB)
(74) Representative: Stevens, Brian Thomas

(56) References cited:
- EP-A- 0 054 259
- EP-A- 0 067 475
- EP-A- 0 164 186
- US-A- 4 417 385
- IBM TECHNICAL DISCLOSURE BULLETIN, vol. 22, No. 4, September 1979, pages 1464-1465

## Description

This invention relates to a method of manufacturing a semiconductor device, in particular a vertical double diffused insulated gate field effect transistor.

Various methods of manufacturing semiconductors are known which comprise providing a conductive layer on a surface of a semiconductor body, the conductive layer being formed with at least one opening and growing insulating material on the one surface to cover the conductive layer. In so far as the manufacture of insulated gate field effect transistors is concerned, a known method comprise providing a conductive gate layer on an insulating layer on one surface of a semiconductor body to form an insulated gate structure having a gate region within which is provided an opening, introducing impurities into the semiconductor body to form a source region of one conductivity type registering with the insulated gate structure and a channel area of the opposite conductivity type underlying the gate region and growing insulating material on the said surface to cover the insulated gate structure.

One such method of manufacturing an insulated gate field effect transistor is described in the paper by H. Esaki and O. Ishikawa entitled 'A 900MHz 100W VD-MOSFET with silicide gate self-aligned channel' published in the proceedings of the 1984 IEDM at pages 447 to 450.

The IGFET described in the afore-mentioned paper is of the DMOST type, that is the channel length within the device is accurately defined by double lateral diffusion of different impurities using, as described, the gate layer as a mask. The IGFET is also of the vertical configuration having its source and drain electrodes on opposite major surfaces of the semiconductor body and has an interdigitated source-gate structure. As described in the paper, the centre of each gate finger of the interdigitated source-gate structure is removed so as to reduce drain-gate capacitance to enable high power gain at the relatively high frequency of 900MHz referred to in the paper.

EP-A-67475 similarly describes a vertical DMOST in which the centres of the gate fingers may be removed or formed of a more highly resistive material than the edges of the gate fingers so as to reduce gate drain capacitance. As described in EP-A-67475, the gate fingers are defined by a polycrystalline silicon layer of relatively high resistivity and a doping element is diffused laterally into the edges of the layer so as to form more highly conductive strips along the edges of the gate fingers. The central more highly resistive polycrystalline silicon part of each gate finger may be left in place or may be removed by an appropriate etching technique.

The invention concerns a method of manufacturing a vertical double diffused insulated gate field effect transistor, which method comprises providing an insulating layer on one of two opposed surfaces of a semiconductor body, forming an insulated gate structure by providing separate conductive gate regions on the insulating layer with an opening smaller than the distance between adjacent conductive gate regions, said openings being provided through each conductive gate region to the insulating layer, growing insulating material to cover the conductive gate regions and the areas between the conductive gate regions, the openings in the conductive gate regions being sufficiently small and the growth of the insulating material being continued for a sufficiently long period that insulating material growing on edges of the conductive gate regions bounding the openings meets to close the openings, forming windows through the insulating material on the areas between the conductive gate regions by etching the insulating material anisotropically towards the surface of the semiconductor body so that insulating material remains on edges of the conductive gate regions, bounding at least part of the windows formed within the insulating material by the anisotropic etching and leaving the openings in the conductive gate regions closed, introducing impurities of the one and the opposite conductivity type via the windows, using the conductive gate regions and the insulating material as a mask, into the semiconductor body, causing said impurities to diffuse into the semiconductor body to form source regions of one conductivity type within body regions of the opposite conductivity type, said body regions comprising channel areas underlying the conductive gate regions, so that the channel areas provide a gateable conductive path for the flow of charge carriers of the one conductivity type between the source regions and a drain region of the one conductivity type.

It should be understood that, as used herein, the term growing includes all methods of providing insulating material on the surface and thus includes, for example, depositing the insulating material on the surface.

Thus by using a method in accordance with the invention, because the openings are sufficiently small and the insulating material is grown for a sufficiently long period that insulating material growing on the edges of the conductive gate regions meets to cover or close the openings, insulating material remains to cover, that is at least partially to fill, the openings within the conductive gate regions after the anisotropic etching step. Where the growth of the insulating material is substantially isotropic then growth should be continued until the insulating material forms a layer having a thickness equal to at least half the width of the openings. The insulating material left in the openings within the conductive gate regions provides some passivation of the surface.

Furthermore, any steps in the top surface will be reduced and smoothed out if not removed entirely so that the top surface extending over the openings will be flatter than it would have been if the openings were not at least partially filled by insulating material, thus reducing the possibility of weak points in metallisation later provided to overlie the top surface to contact the gate conductive regions and/or the semiconductor surface.

The insulating material remaining on edges of the conductive gate regions to define at least part of the window also serves to enable registration of the source regions and channel areas with the conductive gate regions while the insulating material remaining in the opening prevents the surface beneath the opening from being contaminated by the impurities. Thus, an IGFET with a hollow gate structure can be formed without the necessity for a final step of removing a central part of the gate region. Furthermore as the opening within the gate regions may be defined at the same time and with the same step as the gate region boundary, tolerance problems may be minimised enabling more precise alignment of the source regions and channel areas to the hollow gate structure.

The windows in the insulating material will normally, but need not necessarily, extend sufficiently through the insulating material to expose the semiconductor body surface. For example, the impurities to form the source regions and channel areas may be implanted via windows which do not extend right through the insulating material but which define a thinner region of insulating material of small enough thickness to enable the desired implantation of impurities but which also provides some protection for the surface.

In an embodiment of the present invention each source region may be formed within a body region of the opposite conductivity type with part of the body region providing the associated channel area and the method may further comprise shorting the body region to the source region by providing one or more masking regions extending across the window formed by the anisotropic etching so that the masking region(s) and the window define therebetween one or more exposed areas of the source region not covered by either the masking region(s) or the insulating material, etching away the said exposed area(s) of the source region to expose an underlying area or areas of the body region, removing the masking region(s) and providing metallisation within the window to short the exposed area(s) of the body region to the source region.

Each window may be elongate and the or each masking region may be provided on the insulating material so as to extend completely across the width but only partly across the length of the window.

Thus, the windows used for introducing the source regions and channel areas may also be used for shorting each body region to the associated source region because the insulating material remaining on edges of the conductive gate regions insulates the conductive gate regions from the source regions to prevent accidental shorting of the source regions to the gate. Such an arrangement enables the alignment tolerances to be reduced both because the same window is used for introducing the impurities and for shorting each source to the associated body region and because the exposed areas of the body regions may be automatically aligned to the contact windows thus avoiding or at least reducing the alignment problems of the known method discussed above and enabling devices with more reproducible characteristics to be produced.

Where the windows are elongate, the masking region(s) may be provided on the insulating layer so as to extend completely across the windows in a direction transverse to the length of the window. Generally, the step of providing the masking region(s) comprises providing a respective plurality of substantially mutually parallel spaced apart masking regions extending transversely across each window so as to define a number of spaced-apart exposed areas of the respective source region within the window. Usually, the respective masking regions extending over each window are equally spaced apart in the direction of the length of the window.

The masking regions may be defined by regularly spaced apertures formed in a masking layer, the width of each aperture being larger than the width of the window or may be defined by strips extending across the window or by any other suitable arrangement, it merely being necessary to ensure that in a direction transverse to the windows the dimensions of the masking regions and spaces therebetween are sufficient to ensure that the masking regions extend completely across the windows where masking is desired and do not extend across the contact windows where no masking is desired even when possible misalignment tolerances are taken into account. It will be appreciated that strip-like masking regions extending transversely, in a preferred arrangement perpendicularly, of the windows may be particularly advantageous as considerable side ways misalignment between the masking regions and the windows may still not affect the positioning of the exposed areas.

The method may further comprise introducing further impurities of the opposite conductivity type through the windows after etching to expose the underlying areas of the body regions and prior to removal of the masking regions to increase the surface doping of the exposed body regions prior to providing source metallisation in the windows.

Each conductive gate region may be elongate and the associated opening may extend along the length of the conductive gate region to form two conductive gate region strips, the anisotropic etching of the insulating material defining a respective window on each elongate side of the conductive gate region and impurities being introduced into the semiconductor body to form a respective source region aligned with each elongate edge of the conductive gate region and a respective channel area underlying each conductive gate region strip. Each conductive gate region may form a single cell of the IGFET with the two adjacent source regions, underlying channel areas and an associated drain region. The device may consist of many such cells having a common drain region disposed adjacent a surface of the semiconductor body opposite the said surface. In such an arrangement, the device may have spaced-apart elongate conductive gate regions interconnected by transversely extending conductive strips provided by the conductive layer forming the conductive gate regions.

Depending upon the manner in which the insulating material is grown, the anisotropic etching may expose the surface of the conductive layer forming the conductive gate regions. Metal may be deposited on surfaces exposed by the anisotropic etching. For example a refractory metal may be deposited on any exposed silicon surface and annealed to form a self-aligned refractory metal silicide. Where the source regions are shorted to the underlying body regions as discussed above, the conductive gate regions will normally be protected by an etch resistant layer, for example a silicon nitride layer, during the etching step to expose the p body region. The silicon nitride and any other insulating layer may then be removed to expose the conductive gate regions for silicidation after the etching to expose areas of the body regions. The silicidation may be provided in addition to or in replacement of further doping of the exposed body regions.

Of course, the windows need not necessarily expose the surface of the semiconductor body and the anisotropic etching may result in only the top surfaces of the conductive gate regions being exposed for silicidation. Alternatively, where the conductive gate regions are polycrystalline silicon gate regions formed on a silicon body the insulating material may be grown by a method, for example wet oxidation, which results in thicker insulating material over the conductive gate regions so that only the areas of the semiconductor body surface within the windows are exposed for silicidation.

It should be noted that EP-A-54259 describes a method of manufacturing an insulated gate field effect transistor of the lateral type (that is with the source and drain regions adjacent the same surface of the semiconductor body) in which insulating material covering a surface of a silicon body carrying an insulated polycrystalline silicon gate is etched anisotropically to define with field oxide on the surface a window on either side of the gate for introducing impurities to form a source and a drain region on respective sides of the gate. Refractory metal is deposited on surfaces exposed by the anisotropic etching (which may or may not include the surface of the gate) in such a manner so as to form either a metal layer or a refractory metal silicide self aligned to the gate.

In order that the invention may be more readily understood, embodiments thereof will now be described, by way of example, with reference to the accompanying drawings, in which:
Figures 1a to 1e are schematic cross-sectional views illustrating, in sequence, various steps of a method in accordance with the invention for manufacturing an insulated gate field effect transistor;
Figure 2 is a schematic cross-sectional view taken along the line II-II in Figure 3 illustrating part of an insulated gate field effect transistor manufactured by a method in accordance with the invention; and
Figure 3 is a schematic top plan view illustrating part of the insulated field effect transistor shown in Figure 2.

It should of course be appreciated that the various figures are not drawn to scale and that, moreover, in the interests of clarity the dimensions of parts of the figures may have been enlarged or reduced.

Referring now to the drawings, there is illustrated a method of manufacturing a vertical double diffused insulated gate field effect transistor, which method comprises providing an insulating layer (16) on one (4) of two opposed surfaces of a semiconductor body (1), forming an insulated gate structure by providing separate conductive gate regions (8) on the insulating layer (16) with an opening (10) smaller than the distance (7) between adjacent conductive gate regions (8), said openings being provided through each conductive gate region to the insulating layer (16), growing insulating material (16') to cover the conductive gate regions (8) and the areas (7) between the conductive gate regions (8), the openings (10) in the conductive gate regions (8) being sufficiently small and the growth of the insulating material (16') being continued for a sufficiently long period that insulating material growing on edges (8''a) of the conductive gate regions (8) bounding the openings (10) meets to close the openings (10), forming windows (18) through the insulating material (16') on the areas (7) between the conductive gate regions (8) by etching the insulating material (16') anisotropically towards the surface (4) of the semiconductor body (1) so that insulating material (17,19) remains on edges of the conductive gate regions (8), bounding at least part of the windows (18) formed within the insulating material by the anisotropic etching and leaving the openings (10) in the conductive gate regions (8) closed, introducing impurities of the one and the opposite conductivity type via the windows (18), using the conductive gate regions (8) and the insulating material (17,19) as a mask, into the semiconductor body (1), causing said impurities to diffuse into the semiconductor body (1) to form source regions (2) of one conductivity type within body regions (12) of the opposite conductivity type, said body regions (12) comprising channel areas (13) underlying the conductive gate regions (8), so that the channel areas (13) provide a gateable conductive path for the flow of charge carriers of the one conductivity type between the source regions and a drain region of the one conductivity type.

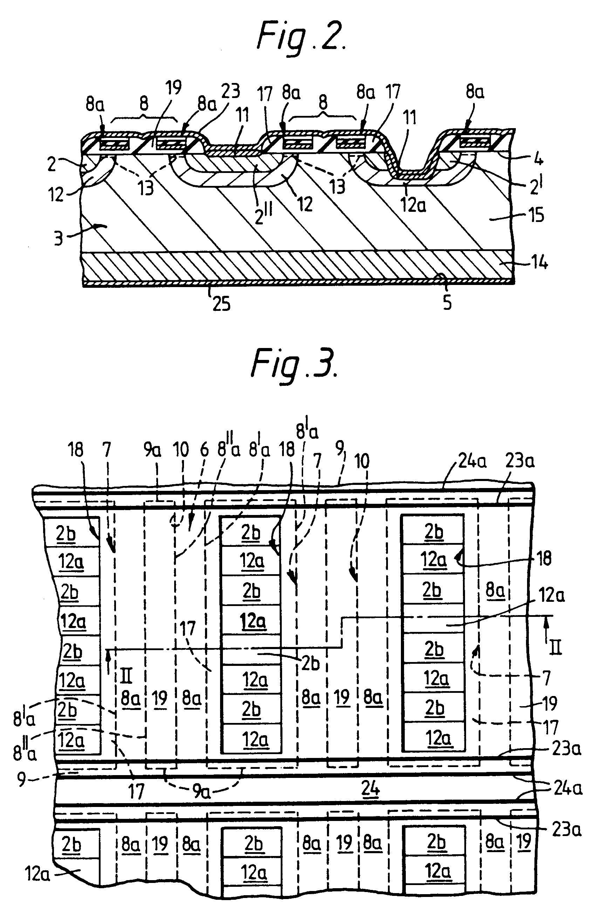

The IGFET shown in Figures 2 and 3 is a vertical DMOS transistor (DMOST) having an interdigitated structure suitable for use at high frequencies, for example UHF frequencies, typically in the range of 1GHz (Gigahertz). The DMOST is considered to be of vertical configuration because, as shown in Figure 2, the semiconductor body 1 of the DMOST has source and drain regions 2 and 3 disposed at respective ones of two opposed major surfaces 4 and 5 of the semiconductor body so that, in operation of the device, current flows between the two opposed major surfaces 4 and 5.

A conductive gate layer 6 of the IGFET has regularly arranged apertures 7 which, as shown, are rectangular and define parallel spaced-apart rectangular conductive gate regions 8 hereinafter referred to as gate fingers connected by transversely extending conductive strips or bus bars 9. Each gate finger 8 is formed with a central rectangular opening 10 which extends along the length of the gate finger 8 dividing it into two gate finger strips 8a. Thus, together with edges 9a of the associated transversely extending bus bars 9, outer edges 8'a of the gate finger strips 8a define the apertures 7 while inner edges 8''a of the gate finger strips define the openings 10.

It should of course be appreciated that although a rectangular geometry has been shown for the gate layer 6, any other suitable geometry could be used, depending upon the desired source region geometry.

In the arrangement shown in Figures 2 and 3, a number of source regions 2 are provided adjacent the major surface 4 while only a single drain region 3, common to all the source regions 2, is provided adjacent the major surface 5.

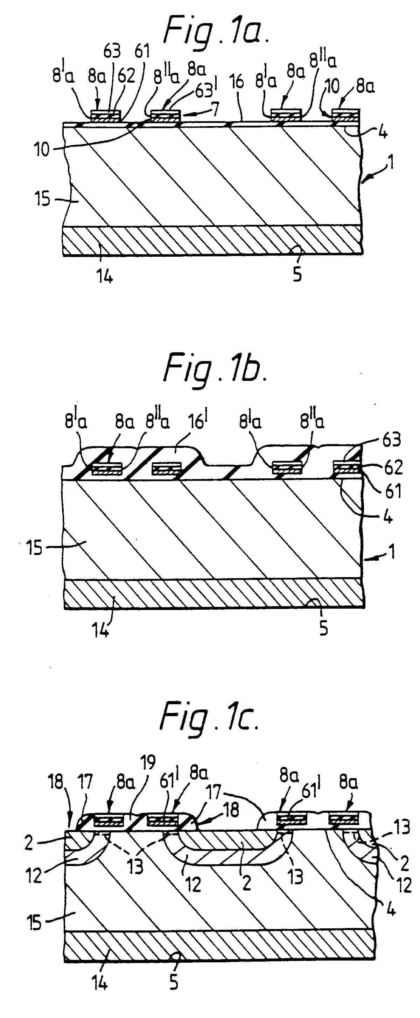

As mentioned above the IGFET shown in Figures 2 and 3 is a DMOST, that is an IGFET in which the channel length is accurately defined by double lateral diffusion of different impurities in the semiconductor body. Thus by introducing impurities via the apertures 7 in the gate layer 6 as will be described hereinafter the gate layer is used as a mask and each source region 2 is formed within a respective body region 12 of the opposite conductivity type so that the boundary of each source region 2 is aligned with edges of the associated aperture and part of the associated body region underlies each of the same two gate finger strips 8a to form respective channel areas 13 under each gate finger strip 8a each extending between a respective source region 2 and the drain region 3. As will be appreciated from Figures 1c and 2, in particular, each source region 2 is associated with two channel areas 13 and therefore two gate fingers 8. Adjacent source regions, for example source regions 2' and 2'' in Figure 2, form with the gate finger 8 and underlying channel areas 13 disposed between the two sources a cell of the IGFET so that apart from at the periphery of the active area of the device, each source region 2 is common to two cells. Typically the IGFET will have hundreds of such cells. As shown, the cells are of rectangular configuration although, of course, any suitable geometry could be used.

As will be discussed in greater detail hereinafter openings 2a are provided in the source regions 2 to expose areas 12a of the body regions 13 so that each source region is shorted to the associated body region by the later applied source metallisation.

A method embodying the invention for manufacturing the IGFET shown in Figures 2 and 3 will now be described and further features of the IGFET will become apparent from the following description.

The semiconductor body 1 comprises an n+ conductivity type monocrystalline silicon substrate 14 on which is grown epitaxially a more highly resistive n conductivity type monocrystalline silicon layer 15. Typically the substrate 14 may have a resisitivity of 10⁻³ ohm cm and a thickness of 250 micrometres while the epitaxial layer 15 may have a resistivity of 1 ohm cm and a thickness of 8 micrometres.

An oxide layer 16 (Figure 1a) typically of 0.07 micrometres thickness is grown on the surface 4 of the layer 15 by conventional thermal techniques and a gate layer 6 is then deposited on the oxide layer 16. In this particular example, the gate layer 6 has a composite layer structure. Thus, a polycrystalline silicon layer 61 is deposited on the oxide layer 15 followed by an insulating layer 62, for example a silicon dioxide layer and then an etch-resistant layer 63 of, for example, silicon nitride. Using conventional masking and etching techniques unwanted parts of the composite gate layer 6 are removed so as to form the hollow gate fingers 8 interconnected by the bus bars 9 (Figures 2 and 3).

In order to provide the required low resistivity, the polycrystalline silicon gate layer 61 is doped with, for example, boron or phosphorus. Although the layer 61 may be deposited as a doped layer, doping may be carried out after deposition and patterning of the gate layer 6. For example, the doping of the gate layer 6 may occur during formation of the source and body regions 2 and 12 or may be by lateral diffusion of, for example, boron into exposed edges of the patterned gate layer as described in EP-A-67475. In the latter case, the openings 10 in the gate fingers 8 will normally (but not necessarily) be formed after doping of the patterned gate layer 6 as described in EP-A-67475.

Of course, the gate layer 61 need not necessarily be a polycrystalline silicon layer but could be any suitable conductive layer, for example a refractory metal layer, a refractory metal silicide layer (for example a platinum silicide layer) deposited on the oxide layer 16 or a composite of two or more of the above mentioned materials.

After the gate layer 6 has been formed, insulating material 16ʹ, for example silicon dioxide is deposited on the surface 4 by an appropriate vapour deposition technique.

The insulating material grows on all exposed surface, that is the surface 4, where exposed, the surface 63ʹ of the gate layer and edges 9a and 8ʹa and 8ʺa of the gate layer 6.

The separation of the two gate finger strips 8a of each gate finger is sufficiently small and the period for which insulating material is deposited is sufficiently long that insulating material growing on the edges 8ʺa of the gate finger strips 8a laterally of the elongate gate fingers 8 (that is across the surface 4) meets or merges to cover completely the openings 10.

It will of course be appreciated that the meeting or merging of the insulating material growing on the edges 8ʺa does not depend merely on the separation of the edges 8ʺa within a gate finger 8 that is the width of the openings 10 but depends on the thickness of insulating material grown on the edges 8ʺa. Where the thickness of the composite gate layer 6 is comparable to the width of the openings 10 and the growth of the insulating material is substantially isotropic (that is the insulating material grows to substantially the same thickness on the edges 8ʹa and 8ʺa of the gate layer as on the surface 63ʹ of the gate layer, then the insulating material should be grown for sufficient time to have a thickness of at least half the width of the openings 10 so that the insulating material growing laterally of opposed gate edges 8ʺa meets to close or cover the openings 10. However, for practical purposes, the width of the openings 10 should be sufficiently small to ensure that only a reasonable thickness of insulating material growing on the edges 8ʺa is required to fill the openings 10 as too thick a layer of insulating material could place undue strain on the semiconductor body and would, moreover, as will be appreciated from the following description, make the subsequent etching process rather time consuming.

In the particular example being described, the gate fingers 8 may have a width of 3 micrometres and be separated by apertures 7 of the same width while the central openings 10 within the gate fingers may have a width of one micrometre so defining two gate finger strips 8a each one micrometre wide. With such dimensions, then if the growth of the insulating material were perfectly isotropic continuing growth until a thickness of just over 0.5 micrometres would be sufficient to ensure that the openings 10 were covered by the meeting or merging insulating material growing laterally of the gate finger strips 8a. However as the growth of the insulating material may not be perfectly anisotropic but may for example be smaller on the upstanding edges 9a, 8ʹa and 8ʺa of the conductive gate layer 6 than on the surface 63ʹ of the gate layer 6, growth should be continued for a short period after a thickness of 5 micrometres has been reached to ensure that the openings 10 are completely covered by the laterally growing insulating material. Figure 1b illustrates schematically the thickness of the insulating material when growth is stopped.

When the growth of the insulating material is stopped, the insulating material is etched anisotropically toward the surface 4 using, for example, a reactive ion etching technique using, for example, a CHF₃ and Argon gas mixture to expose the surface 4 beneath the apertures 7 in the gate layer 6 and the surface 63ʹ of the composite gate layer 6. As the anisotropic etching attacks the insulating material in a direction normal to the surface 4, a given vertical thickness of insulating material is removed. Thus when the surface 4 within the apertures 7 and the surface 63ʹ of the gate layer 6 are exposed by the anisotropic etching, fillets 17 of insulating material of the original laterally grown thickness remain on the edges 9a, 8ʹa of the gate layer 6 so defining a respective window 18 in the insulating material disposed above and within each aperture 7. As the growth of insulating material was continued so that insulating material growing laterally of the edges 8ʺa of each gate finger 8 met to cover the openings 10, the anisotropic etching does not expose the surface 4 within the openings 10 but leaves a thickness of insulating material 19 extending to the level of the surface 63ʹ so providing a substantially flat surface between and over the two gate finger strips 8a of each gate finger 8. Figure 1c illustrates schematically a semiconductor body on which the anisotropic etching step has just been completed.

Impurities are then introduced into the semiconductor body via the windows 18 to form the body regions 12 and source regions 2. Thus, in one example, boron ions are implanted via the windows 18 using, for example, a dose of 10¹³cm⁻² and an energy of 150keV followed by a drive-in at 1050 degrees Celsius for 30 minutes. A second ion implantation step through the windows 18 using phosphorous ions at an energy of 50keV and a dose of 10¹⁵cm⁻² is then carried out followed by an annealing step, for example ten minutes at 1000 degrees Celsius. Thus p-type body regions 12 and n-type source regions 2 are formed, with the length of the channel areas being determined by the difference in the lateral diffusion lengths of the n-type and p-type dopants under the above conditions. Knowing the diffusion lengths of the dopants under the particular conditions used, the thickness of the insulating material fillets 17 can be selected so that the source regions 2 are aligned, as shown in Figure 1c, to the edges 8ʹa of the gate fingers 8. The channel areas 13 may be aligned with the edges 8ʺa of the gate fingers 8 or, alternatively as shown, the gate finger strips 8a may extend laterally toward one another beyond the channel areas 13 so as to provide a field plating effect. The source and body regions may be formed so as to extend, respectively, to a depth of 0.5 and 1.0 micrometres below the surface 4.

The insulating material covering the openings 10 prevents dopants being introduced into the semiconductor body beneath the openings 10 during formation of the source regions 2 so enabling the hollow gate structure to be provided prior to formation of the source and body regions 2 and 12.

Although as described above, the source and body regions 2 and 12 are formed by ion implantation another suitable process, for example a diffusion process, could be used where the windows 18 expose the surface 4.

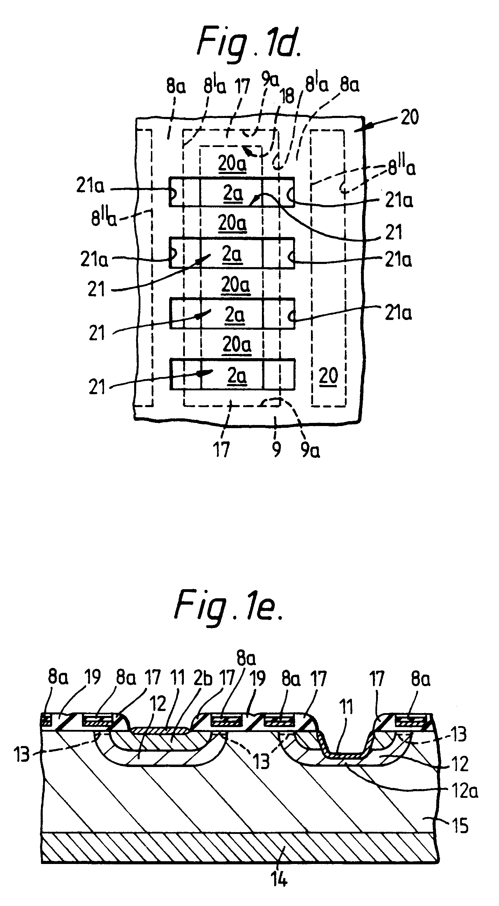

After formation of the source and body regions 2 and 12, a suitable resist layer 20 is then applied (Figure 1d) to the surface of the insulating material and is patterned using conventional techniques to define apertures 21 in the resist layer so that masking regions 20a of the resist layer 20 extend completely across the windows 18 in the insulating material.

Each window 18 is associated with one or more masking regions 20a so that the window 18 and associated masking region(s) 20a together define one or more exposed areas 2a of the associated source region 2, that is areas 2a of the source region 2 not covered by either the masking region(s) or the insulating material within which the window 18 is defined. The exposed area(s) 2a within each window 18 are thus not defined merely by the masking region(s) 20a but by the combination of the masking region(s) 20a and the windows 18. As shown, the masking region(s) 20a define(s) one dimension of the exposed area(s) 2a and the contact window 18 defines the other dimension of the exposed area(s) 2a.

Although any desired suitable shape could be used for the apertures 21, as shown each aperture 21 is rectangular to fit with the rectangular pattern adopted for the windows 18 and gate layer 6. The dimension or width of each aperture 21 in a direction transverse (in the example shown, perpendicular) to the length of the associated window 18 is greater, usually by at least two times the maximum misalignment error which could occur, than the width of the window 18 so that, even when possible misalignment errors are taken into account, edges 21a of the apertures 21 extending longitudinally of the associated window 18 do not overlap the elongate edges 18a of the window.

Alternatively, the resist layer 20 may be formed as a series of discrete strips extending transversely, in the example shown perpendicularly, of the windows 18 so as to reduce even further the possibility of the resist layer overlapping the longitudinal edges of the contact window except in places where the resist layer extends completely across the contact windows.

Thus, the resist layer 20 only covers the parts of the windows 18 which it is desired to mask and where the resist layer does cover part of a window 18 the resist layer extends completely across the width of the window 18. The resist layer should extend transversely beyond the contact window on each side for a distance equal to at least the maximum tolerance error which could be expected.

Within each window 18, the relative sizes of the exposed source areas 2a and the unexposed source areas 2b covered by the resist masking regions 20a may be in any desired ratio. In the arrangement shown, the resist layer 20 is selected so as to provide alternate exposed and covered equal area areas 2a and 2b of the source region. It should of course be appreciated that the exposed and covered areas 2a and 2b may have any desired shape. The number of exposed and covered areas will depend upon the particular device and the length of the gate fingers 8, the latter being determined by the desired gate RC time constant.

Using conventional etching processes the exposed areas 2a of the source regions are then removed so as to expose the underlying areas 12a of the p-type body regions 12. The resist layer 20 is then removed.

After formation of the source and body regions 2 and 12 and exposure of the body areas 12 as described above, a refractory metal silicide layer 11 may be formed on the exposed areas of the surface 4 of the silicon body. The gate layer 61 may also be exposed using an appropriate etchant to remove the silicon nitride layer 63 and insulating layer 62 for subsequent silicidation. In such an arrangement it would also be necessary to provide fresh insulating material over the silicided gate layer to prevent shorting to and to reduce the capacitance with the subsequent source metallisation. The metal silicide layer 11 may be formed in a known manner by depositing a refractory metal, for example tungsten, molybdenum, platinum or titanium, on the semiconductor body and then annealing, for example thermally or by use of a laser beam, so as to form refractory metal silicide only over the exposed areas of the silicon surfaces. Metal remaining on the insulating material is removed by an appropriate method, for example an acid treatment.

Although the method of shorting the p body regions 12 to the source regions 2 described above is particularly advantageous, alternative methods could be used. Thus, for example, after implanting of the impurities via the windows 18 to form the p body regions 12 and the source regions 2, an appropriate masking layer (similar to the layer 20) may be provided over the insulating material so as to protect the areas 2b of the source regions from a subsequent p-type overdoping implantation to form p+ conductivity type areas 12a of the p body regions 12 extending to the surface. Thus, after the implantation steps, alternate source and body regions 2b and 12a are provided at the surface 4. It is possible, in such a case, for the refractory metal silicide to be formed prior to the formation of the source and drain regions, the necessary impurities being implanted through the refractory metal silicide. A technique using interface mixing with an ion beam can be used to enhance silicide formation. As group III or IV dopants may be used as the ion beam, the silicide formation and doping of the underlying silicon to form the source and body regions can be carried out simultaneously with the silicide formation on the exposed silicon surfaces. When such a method is used, the refractory metal silicide layer may of course be formed after, with or before the source and body regions 2 and 12.

In an alternative arrangement, the source regions 2b may be implanted through a mask similar to the mask 20 to provide alternate source and drain regions. Such an arrangement will, of course, however result in a shorter channel length.

Where no etching step is carried out to short the p body 12 to the source region 2, then the surface 61ʹ of the conductive gate layer 61 may be exposed during the anisotropic etching. Indeed in such an arrangement, there would be no necessity for the conductive gate layer 6a to be protected and the layers 62 and 63 could be omitted. However, in such an arrangement, the exposed surface of the conductive gate layer 61 would, of course, have to be covered by a subsequent growth of insulating material through an appropriate mask to prevent shorting to subsequent overlying source metallisation. Where the upper layer of the conductive gate layer 61 was formed of polycrystalline silicon, a self-aligned refractory metal silicide can be formed on the exposed surface 61′.

Although in the method described above the insulating material is formed by an appropriate vapour deposition technique, the insulating material may, for example where the gate layer is formed of polycrystalline silicon be grown by oxidising the silicon surface 4 and the gate layer 6.

When the body regions and source regions 2 and 12 and metal silicide (if required) have been formed as described above, then metallisation can be deposited on the surface 4 to form the source and gate metallisation. Of course, where the gate layer surface 61ʹ has been exposed for the purposes of silicidation insulating material will be deposited over the exposed silicided gate layer surface 61ʹ using an appropriate mask prior to depositing the metallisation so as to prevent shorting of the gate to the source. Windows will of course be formed in the insulating material to enable the metallisation to contact the bus bars 9. After the metallisation has been deposited on the insulating material to contact the bus bars 9 and to short the p body regions 12 to the source regions 2, known resist masking and etching techniques are used to define separate source metallisation 23 and bus bar or gate metallisation 24. Although in the interests of clarity the source metallisation is omitted in Figure 3, the edges of the source metallisation which of course extends over the windows 18 is illustrated by the thick lines 23a in Figure 3, the edges of the bus bar metallisation similarly being defined by the thick lines 24a. The source metallisation 23 thus shorts the exposed p body regions to the exposed source regions 2a within each window 18.

The drain of the transistor is formed by the n-type substrate 3 and an electrode 25 is provided on the free surface 4 of the substrate 3 to form the drain contact. The electrode may be, for example, gold-antimony which is deposited in a known manner.

As will be appreciated from the above, the method described enables a particularly compact structure to be provided. In particular, a hollow gate structure can be provided so as to reduce gate drain capacitance in a manner which enables the source and drain regions to be self-aligned to the hollow gate structure. As the hollow gate structure is provided before and not after the introduction of the impurities to form the body and source regions, the possibility of misaligning the central aperture in the gate fingers with respect to the source and body regions is removed or at least minimised so enabling alignment tolerances to be minimised.

Further, by using anisotropic etching to define the windows for introducing the impurities to define the source and body regions, the source and body regions may be self-aligned to the gate structure. Also as the same window can be used for any silicidation step and for the contact windows for the source metallisation alignment tolerances can be further minimised.

It should of course be appreciated that the method described above may be suitable for manufacturing semiconductor devices other than vertical IGFETS. In particular the method by which the insulating material is grown and then anisotropically etched to leave insulating material filling gaps between the conductive gate finger strips 8a of a gate finger could be applied to other conductive gate layers provided on semiconductor bodies or substrates.

The invention may, of course, be applicable to semiconductor devices made from materials other than silicon. Also, although the invention finds particular application in relation to IGFETs with interdigitated structures it may be applicable in relation to other cellular structures. As will be appreciated, the conductivity types of the various regions of the IGFETs described above could be reversed.

From reading the present disclosure, other modifications will be apparent to persons skilled in the semiconductor art for example persons skilled in the design, manufacture and/or use of semiconductor devices.

It has been stated above that the drawings illustrate examples of embodiments of the invention and, in order to avoid any misunderstanding, it is hereby further stated that, in the following claims, where technical features mentioned in any claim are followed by reference signs relating to features in the drawings and placed between parentheses, these reference signs have been included in accordance with Rule 29(7) EPC for the sole purpose of facilitating comprehension of the claim, by reference to an example.

## Claims

1. A method of manufacturing a vertical double diffused insulated gate field effect transistor, which method comprises providing an insulating layer (16) on one (4) of two opposed surfaces of a semiconductor body (1), forming an insulated gate structure by providing separate conductive gate regions (8) on the insulating layer (16) with an opening (10) smaller than the distance (7) between adjacent conductive gate regions (8), said openings being provided through each conductive gate region to the insulating layer (16), growing insulating material (16') to cover the conductive gate regions (8) and the areas (7) between the conductive gate regions (8), the openings (10) in the conductive gate regions (8) being sufficiently small and the growth of the insulating material (16') being continued for a sufficiently long period that insulating material growing on edges (8''a) of the conductive gate regions (8) bounding the openings (10) meets to close the openings (10), forming windows (18) through the insulating material (16') on the areas (7) between the conductive gate regions (8) by etching the insulating material (16') anisotropically towards the surface (4) of the semiconductor body (1) so that insulating material (17,19) remains on edges of the conductive gate regions (8), bounding at least part of the windows (18) formed within the insulating material by the anisotropic etching and leaving the openings (10) in the conductive gate regions (8) closed, introducing impurities of the one and the opposite conductivity type via the windows (18), using the conductive gate regions (8) and the insulating material (17,19), as a mask, into the semiconductor body (1), causing said impurities to diffuse into the semiconductor body (1) to form source regions (2) of one conductivity type within body regions (12) of the opposite conductivity type, said body regions (12) comprising channel areas (13) underlying the conductive gate regions (8), so that the channel areas (13) provide a gateable conductive path for the flow of charge carriers of the one conductivity type between the source regions and a drain region of the one conductivity type.

2. A method according to Claim 1, wherein each source region (2) is formed within a body region (12) of the opposite conductivity type, part of the body region (12) providing the channel area (13) and the method further comprises shorting each body region (12) to the associated source region (2) by providing one or more masking regions (20a) extending across the window (18) formed by the anisotropic etching so that the masking region(s) (20a) and the window (18) define therebetween one or more exposed areas (2a) of the source region (2) not covered by either the masking region(s) (20a) or the insulating material (17), etching away the said exposed area(s) (2a) of the source region (2) to expose an underlying area or areas (12a) of the body region, removing the masking region(s) (20a) and providing metallisation (23) within the window (18) to short the exposed area(s) (12a) of the body region (12) to the source region (2).

3. A method according to Claim 2, wherein each window (18)is elongate and the or each masking region (20a) is provided on the insulating material (16') so as to extend completely across the width but only partly across the length of the associated window (18).

4. A method according to any one of the preceding Claims, comprising providing the conductive gate regions (8) such that each conductive gate region (8) is elongate and the opening (10) extends along the length of the conductive gate region to form two conductive gate region strips (8a).

5. A method according to Claim 1,2 or 3, comprising providing the conductive gate regions (8) such that each conductive gate region (8) is elongate and the opening (10) extends along the length of the conductive gate region (8) to form two conductive gate region strips (8a), the anisotropic etching of the insulating material (16') defining a respective window (17) on each elongate side (8'a) of each conductive gate region (8) and the impurities being introduced into the semiconductor body to form a respective source region (2) aligned with each elongate edge (8'a) of each conductive gate region (8) and a respective channel area (13) underlying each conductive gate region strip (8a).

6. A method according to any one of Claims 1 to 5, wherein the anisotropic etching exposes a top surface of the conductive gate regions (8).

7. A method according to any one of the preceding claims, further comprising depositing metal (11) on surfaces exposed by the anisotropic etching to reduce the resistivity thereof.

8. A method according to any one of the preceding claims, wherein at least one of the surface (4) of the semiconductor body (1) and the surfaces of the gate conductive regions (8) is formed of silicon and the method further comprising forming a refractory metal silicide (11) on surfaces exposed by the anisotropic etching.

## Patentansprüche

1. Verfahren zum Herstellen eines vertikalen doppeldiffundierten Isolierschicht-Feldeffekttransistors dargestellt, und dieses Verfahren umfaßt das Anordnen einer Isolierschicht (16) auf einer (4) von zwei einander gegenüberliegenden Oberflächen eines Halbleiterkörpers (1), das Bilden einer Isolierschichtstruktur durch das Anordnen getrennter leitenden Gate-Gebiete (8) auf der Isolierschicht (16) mit einer Öffnung (10) kleiner als der Abstand (7) zwischen benachbarten leitenden Gate-Gebieten (8), wobei die Öffnungen durch jedes leitende Gate-Gebiet nach der Isolierschicht (16) angebracht sind, das Züchten von Isoliermaterial (16') zum Bedecken der leitenden Gate-Gebiete (8) und der Bereiche (7) zwischen den leitenden Gate-Gebieten (8), wobei die Öffnungen (10) in den leitenden Gate-Gebieten (8) klein genug sind und das Züchten des Isoliermaterials (16') ausreichend lange Zeit fortgesetzt wird, daß auf Rändern (8''a) der leitenden Gate-Gebiete (8) zum Begrenzen der Öffnungen (10) gezüchtetes Isoliermaterial zusammentrifft, um die Öffnungen (10) zu schließen, das Bilden von Fenstern (18) durch das Isoliermaterial (16') auf den Bereichen (7) zwischen den leitenden Gate-Gebieten (8) durch anisotropisches Ätzen des Isoliermaterials (16') nach der Oberfläche (4) des Halbleiterkörpers (1), so daß auf Rändern der leitenden Gate-Gebiete (8) Isoliermaterial (17, 19) zurückbleibt, das wenigstens einen Teil der im Isoliermaterial durch das anisotropische Ätzen gebildeten Fenster (8) begrenzt und die Öffnungen (10) in den leitenden Gate-Gebieten (8) geschlossen läßt, das Einführen von Verunreinigungen vom einen und vom entgegengesetzten Leitfähigkeitstyp über die Fenster (18), unter Verwendung der leitenden Gate-Gebiete (8) und des Isoliermaterials (17, 19) als Maske im Halbleiterkörper (1), und das Hineindiffundieren der Verunreinigungen in den Halbleiterkörper (1) zum Bilden von Sourcegebieten (2) vom einen Leitfähigkeitstyp in den Körpergebieten (12) vom entgegengesetzten Leitfähigkeitstyp, wobei die Körpergebiete (12) Kanalbereiche (13) unter den leitenden Gate-Gebieten (8) enthalten, so daß die Kanalbereiche (13) einen aufsteuerbaren Leitweg für den Ladungsträgerfluß vom einen Leitfähigkeitstyp zwischen den Sourcegebieten und einem Draingebiet vom einen Leitfähigkeitstyp auslöst.

2. Verfahren nach Anspruch 1, worin jedes Sourcegebiet (2) in einem Körpergebiet (12) entgegengesetzter Leitfähigkeit gebildet wird, wobei ein Teil des Körpergebiets (12) den Kanalbereich (13) bildet, und das Verfahren weiter das Verkürzen des Körpergebiets (12) nach dem Sourcegebiet (2) durch das Anbringen eines oder mehrerer Maskiergebiete (20a), die sich über das durch das anisotropische Ätzen gebildete Fenster (18) erstrecken, so daß das Maskiergebiet oder die Maskiergebiete (20a) und das Fenster (18) dazwischen einen oder mehrere belichtete Bereiche (2a) des Sourcegebiets (2) definieren, die nicht durch ein Maskiergebiet oder Maskiergebiete (20a) oder durch das Isoliermaterial (17) bedeckt werden, das Abätzen des belichteten Bereichs (2a) (oder der berichteten Bereiche) des Sourcegebiets (2) zum Belichten eines unterliegenden Bereichs oder unterliegender Bereiche (12a) des Körpergebiets, das Entfernen des Maskiergebiets oder der Maskiergebiete (20a) und das Anbringen von Metallisierung (23) im Fenster (18) zum Kurzschließen des belichteten Bereichs oder der belichteten Bereiche (12a) des Körpergebiets (12) nach dem Sourcegebiet (2).

3. Verfahren nach Anspruch 2, worin jedes Fenster (18) eine längliche Form hat und das oder jedes Maskiergebiet (20a) auf dem Isoliermaterial (16') angebracht wird, um sich vollständig über die Breite, aber nur teilweise über die Länge des zugeordneten Fensters (18) zu erstrecken.

4. Verfahren nach einem oder mehreren der vorangehenden Ansprüche, das das Anbringen der leitenden Gate-Gebiete (8) derart umfaßt, daß jedes leitende Gate-Gebiet (8) länglich ist und die Öffnung (10) sich entlang der Länge des leitenden Gate-Gebiets zur Bildung von zwei leitenden Gate-Gebietstreifen (8a) erstreckt.

5. Verfahren nach Anspruch 1, 2 oder 3, das das Anbringen der leitenden Gate-Gebiete (8) derart umfaßt, daß jedes leitende Gate-Gebiet (8) länglich ist und die Öffnung (10) sich entlang der Länge des leitenden Gate-Gebiets (8) zur Bildung von zwei leitenden Gate-Gebietstreifen (8a) erstreckt, wobei das anisotropische Ätzen des Isoliermaterials (16') ein jeweiliges Fenster (17) auf jeder langen Seite (8'a) des leitenden Gate-Gebiets (8) definiert und die Verunreinigungen in den Halbleiterkörper zur Bildung eines jeweiligen Sourcegebiets (2) in Ausrichtung mit jedem langen Rand (8'a) jedes leitenden Gate-Gebiets (8) eingeführt werden und ein jeweiliger Kanalbereich (13) unter jedem leitenden Gate-Gebietstreifen (8a) liegt.

6. Verfahren nach einem oder mehreren der Ansprüche 1 bis 5, worin das anisotropische Ätzen eine obere Fläche der leitenden Gate-Gebiete (8) exponiert.

7. Verfahren nach einem oder mehreren der vorangehenden Ansprüche, das weiter das Ablagern von Metall (11) auf durch das anisotropische Ätzen exponierten Flächen zum Reduzieren ihres spezifischen Widerstands umfaßt.

8. Verfahren nach einem oder mehreren der vorangehenden Ansprüche, worin wenigstens eine der Oberflächen (4) des Halbleiterkörpers (1) und die Oberflächen der leitenden Gate-Gebiete (8) aus Silizium gebildet ist, und das Verfahren außerdem das Bilden eines feuerfesten Metallsilicids (11) auf durch das anisotropische Ätzen exponierten Flächen umfaßt.

## Revendications

1. Procédé pour la fabrication d'un transistor à effet de champ à porte isolée doublement diffusé vertical, lequel procédé comprend l'application d'une couche isolante (16) sur une surface (4) de deux surfaces opposées d'un corps semiconducteur (1), la formation d'une structure de porte isolée par disposition de régions de porte conductrices séparées (8) sur la couche isolante (16) présentant une ouverture (10) plus petite que la distance (7) comprise entre les régions de porte conductrices adjacentes (8), lesdites ouvertures étant disposées à travers chaque région de porte conductrice sur la couche isolante (16), la formation par croissance de matériau isolant (16') pour recouvrir les régions de porte conductrices (8) et les zones (7) comprises entre les régions de porte conductrices (8), les ouvertures (10) dans les régions de porte conductrices (8) étant suffisamment petites et la croissance du matériau isolant (16') étant continuée pendant une période suffisamment longue pour que le matériau isolant se formant par croissance sur les bords (8''a) des régions de porte conductrices (8) délimitant les ouvertures (10) s'accumule pour fermer les ouvertures (10), la formation de fenêtres (18) à travers le matériau isolant (16') sur les zones (7) comprises entre les régions de porte conductrices (8) par décapage anisotrope du matériau isolant (16') vers la surface (4) du corps semiconducteur (1) de façon que le matériau isolant (17, 19) subsiste aux bords des régions de porte conductrices (8) délimitant au moins une partie des fenêtres (18) formées dans le matériau isolant par le décapage anisotrope et laissant les ouvertures (10) dans les régions de porte conductrices (8) fermées, introduction d'impuretés d'un type de conductivité et du type de conductivité opposé par l'intermédiaire des fenêtres (18), utilisation des régions de porte conductrices (8) et du matériau isolant (17, 19) comme masque dans le corps semiconducteur (1), provoquant la diffusion desdites impuretés dans le corps semiconducteur (1) pour former des régions de source (2) d'un type de conductivité dans les régions de support (12) du type de conductivité opposé, lesdites régions de support (12) comprenant des zones de canal (13) situées au-dessous des régions de porte conductrices (8) de façon que les régions de canal (13) fournissent un trajet conducteur pouvant être fermé pour le flux de porteurs de charge d'un type de conductivité entre les régions de source et une région de drain d'un type de conductivité.

2. Procédé selon la revendication 1, selon lequel chaque région de source (2) est formée dans une région de support (12) du type de conductivité opposé, une partie de la région de support (12) fournissant la zone de canal (13) et le procédé comprend en outre le raccourcissement de chaque région de corps (12) à la région de source associée (2) par disposition d'une ou de plusieurs régions de masquage (20a) s'étendant sur la fenêtre (18) formée par décapage anisotrope de façon que la (les) région(s) de masquage (20a) et la fenêtre (18) définissent entre elles une ou plusieurs zones exposées (2a) de la région de source (2) non recouverte(s) par soit la (les) région(s) de masquage (20a) soit le matériau isolant (17), enlèvement par décapage de ladite (desdites) zone(s) exposée(s) (2a) de la région de source (2) pour exposer une zone ou des zone(s) sous-jacente(s) de la région de corps, enlèvement de la (des) région(s) de masquage (20a) et l'application d'une métallisation (23) dans la fenêtre (18) pour raccourcir la (les) zone(s) exposée(s) (12a) de la région de corps (12) à la région de source (2).

3. Procédé selon la revendication 2, selon lequel chaque fenêtre (18) est allongée et la ou chaque région de masquage (20a) est disposée sur le matériau isolant (16') de façon à s'étendre complètement sur la largeur mais seulement partiellement sur la longueur de la fenêtre associée (18).

4. Procédé selon l'une des revendications précédentes, comprenant l'application des régions de porte conductrices (8) de façon que chaque région de porte conductrice (8) soit allongée et que l'ouverture (10) s'étende sur la longueur dans la région de porte conductrice pour former deux bandes de région de porte conductrices (8a).

5. Procédé selon la revendication 1, 2 ou 3, comprenant l'application des régions de porte conductrices (8) de façon que chaque région de porte conductrice (8) soit allongée et que l'ouverture (10) s'étende dans la longueur de la région de porte conductrice (8) pour former deux bandes de région de porte conductrices (8a), le décapage anisotrope du matériau isolant 16' définissant une fenêtre respective (17) sur chaque face allongée (8'a) de chaque région de porte conductrice (8) et les impuretés étant introduites dans le corps semiconducteur pour former une source de région respective (2) qui est en ligne avec chaque bord allongé (8'a) de chaque région de porte conductrice (8) et une zone de canal respective (13) située au-dessous de chaque bande de région de porte conductrice (8a).

6. Procédé selon l'une des revendications 1 à 5, selon lequel le décapage anisotrope met à découvert une surface supérieure des régions de porte conductrices (8).

7. Procédé selon l'une des revendications précédentes, comprenant en outre le dépot de métal (11) sur les surfaces mises à découvert par le décapage anisotrope pour réduire leur résistivité.

8. Procédé selon l'une des revendications précédentes, selon lequel au moins l'une de la surface (4) du corps semiconducteur (1) et des surfaces des régions de porte conductrices (8) est formée en silicium et la méthode comprend en outre la formation d'un siliciure métallique réfractaire (11) sur les surfaces mises à découvert par le décapage anisotrope.
